Europäisches Patentamt

European Patent Office

Office européen des brevets

(19)

(11) Publication number: 0 403 080 A2

# (12) EUROPEAN PATENT APPLICATION

(21) Application number: 90305283.5

(22) Date of filing: 16.05.90

(51) Int. Cl.5: G02B 6/12

(30) Priority: 10.06.89 GB 8913412

(43) Date of publication of application:
19.12.90 Bulletin 90/51

(84) Designated Contracting States:
DE FR GB IT NL SE

(71) Applicant: PLESSEY RESEARCH CASWELL
LIMITED
Vicarage Lane
Ilford, Essex, IG1 4AQ(GB)

(72) Inventor: Randle, Frederick Arthur
11 Willows Hill, Bradden
Nr. Towcester, Northants(GB)

(74) Representative: Lupton, Frederick
The General Electric Company, p.l.c., Central
Patent Department, Hirst Research Centre
Wembley, Middlesex, HA9 7PP(GB)

(54) Bonding devices.

(57) A method of bonding a device of the type described, comprising forming the upper surface of said base member and/or the lower surface of said substrate with recesses and/or ribs, applying to either or both surfaces a bonding substance, and positioning said substrate on said base member to form a bond with the base member in which the bonding substance is divided into discrete areas whereby to localise stress regions arising in said substance to adjacent said discrete areas.

EP 0 403 080 A2

## BONDING DEVICES

This invention relates to miniature electronic and optoelectronic devices (such as integrated circuits and integrated optoelectronic circuits) which are formed on a substrate and which substrate is to be bonded to a base member, such devices will be referred to herein as "devices of the type described".

Usually such substrate is bonded to the base member by a layer of adhesive or solder spread over the lower surface of the substrate. When the adhesive sets this may cause large stress regions in the substrate created by uneven setting and changes in volume of the adhesive during curing or temperature cycling. In some circumstances these stress regions may disturb the electrical properties of the device, for example a VLSI transistor array or a lithium niobate device having optical diffused waveguides thereon, where such stresses may cause changes in refractive index.

According to the present invention there is provided in one aspect a method of bonding a device of the type described, comprising forming the upper surface of said base member and/or the lower surface of said substrate with recesses and/or ribs, applying to either or both surfaces a bonding substance, and positioning said substrate on said base member to form a bond with the base member in which the bonding substance is divided into discrete areas whereby to localise stress regions arising in said substance to adjacent said discrete areas.

In a further aspect, the invention provides a device of the type described whose substrate is bonded to a base member by a bonding substance, wherein the upper surface of the base member and/or the lower surface of the substrate is formed with recesses and/or ribs whereby the bonding substance is divided into discrete areas and any stresses set up in the bonding process are localised adjacent to the discrete areas.

In accordance with the invention, bulk stresses are eliminated thus preventing stresses reaching the sensitive areas of the device carrying electrical and/or optical components.

In a preferred form of the invention, the base member upper surface is formed with recesses such as grooves or holes to receive the bonding substance; in some circumstances however the lower surface of the substrate may be formed with recesses and/or ribs where the material of the substrate permits.

While the adhesive substance is commonly a resin such as an epoxy, a solder may also be employed.

In carrying out a preferred form of the present invention the baseplate onto which the device is to be bonded is inscribed with depressions to contain the joining material at the same time leaving enough of the surface intact to maintain its original profile. The device rests on the remaining original surface which is matched to the base contours of the device, this being normally planar. The joining material fills the spaces created by the depressions and so links the device to the baseplate. On curing or reflowing any stress exerted by the joining material on the device is confined to the areas of the depression leaving the device free of bulk stresses.

By way of example, embodiment of the invention will now be described with reference to the accompanying drawings, wherein:-

Figure 1 is a schematic cross-sectional view of a device bonded in accordance with the invention;

Figure 2 is a perspective view of a base member having a grooved upper surface in accordance with the invention; and,

Figures 3 and 4 are perspective views of a device bonded to a base member in accordance with two embodiments of the invention.

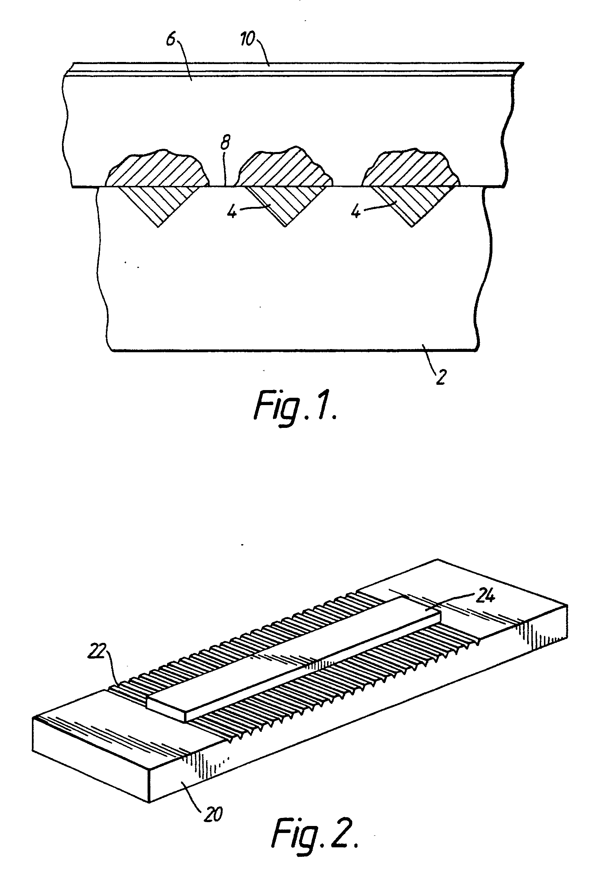

Figure 1 shows an arrangement according to the invention whereby the baseplate 2 is inscribed with V-grooves 4 and a device 6 which is an optoelectronic device comprising a Lithium Niobate substrate 8 between them. Changes in volume of the joining material create localised stresses in the areas shown leaving a waveguide area 10 unaffected.

Referring to figure 2, a baseplate 20 which ideally should be expansion matched to the device material has machined or etched within its top surface a series of parallel V-grooves 22. Joining or bonding material (not shown) is placed on the V-groove and a device 24 is lowered onto the same area. Curing or temperature cycling of the joining material completes the bonding procedure.

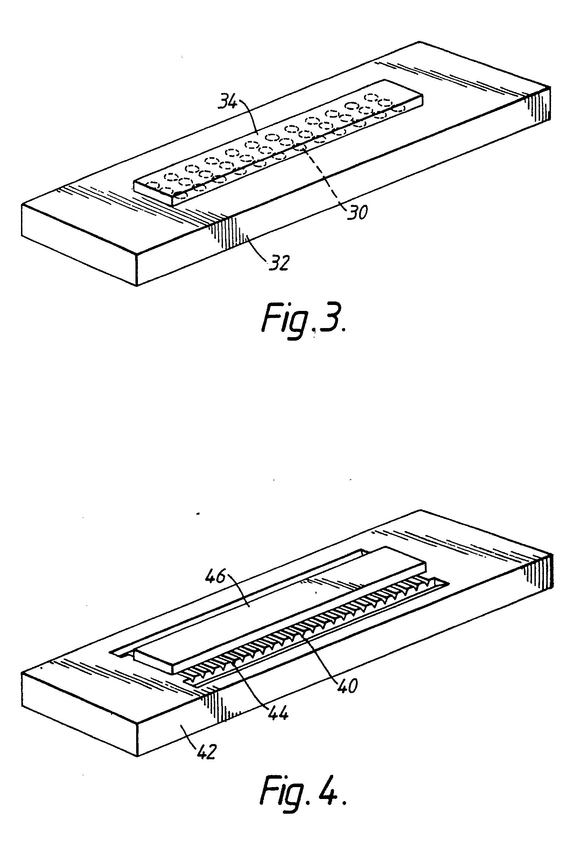

Figure 3 shows an alternative arrangement where the joining material (not shown) enters the joint area through holes 30 drilled through the baseplate 32. A bonding operation of this type is best accomplished by inverting the whole assembly including a device 34 to allow the joining material to move by gravity feed.

A reservoir 40 for the joining material can be provided in the base member 42 alongside grooves 44 along the length of the device 46 as shown in figure 4. The material can flow from the reservoir to the joint area during the bonding operation.

The foregoing description shows the invention to be a simple method of isolating critical stress sensitive regions of a device from changes in volume that may occur during curing or temperature cycling of a joining material.

Important features of the invention are as follows:

1. A method of containing the stress applied to a device by the joining material to a number of small regions at the base of a device well away from vulnerable areas.

2. Bulk stresses exerted over the length and width of a device as a large volume of joining material changed its dimensions is greatly reduced.

3. A method whereby joining material may be supplied to well defined areas of a joint.

4. Small volumes of joining material are used so reducing the volume changes and hence the total stress applied to the device.

5. A method which allows the device to lie in periodic contact with the baseplate along its length reducing the bulk stresses applied to the device.

## Claims

1. A method of bonding a device of the type described, comprising forming the upper surface of said base member and/or the lower surface of said substrate with recesses and/or ribs, applying to either or both surfaces a bonding substance, and positioning said substrate on said base member to form a bond with the base member in which the bonding substance is divided into discrete areas whereby to localise stress regions arising in said substance to adjacent said discrete areas.

2. A device of the type described whose substrate is bonded to a base member by a bonding substance, wherein the upper surface of the base member and/or the lower surface of the substrate is formed with recesses and/or ribs whereby the bonding substance is divided into discrete areas and any stresses set up in the bonding process are localised adjacent to the discrete areas.

3. A method or device as claimed in claim 1 or 2 wherein the device is an optoelectronic device comprising a lithium niobate substrate.

4. A method or device according to any preceding claim wherein the upper surface of the base member is formed with a series of parallel longitudinal grooves.

5. A method or device according to any preceding claim wherein a reservoir for a bonding substance is providing on the base member in communication with said discrete areas.

6. A method or device as claimed in any preceding claim wherein the base member has through holes to permit introduction of said bonding substance to said upper surface from an opposite surface.

7. Methods and devices substantially as described with reference to the accompanying drawings.

## Fig.1.

## Fig.2.

Fig.3.

Fig.4.